Europäisches Patentamt

European Patent Office

Office européen des brevets

(11) Publication number: **0 374 809**
**A2**

## EUROPEAN PATENT APPLICATION

(21) Application number: **89123414.8**

(22) Date of filing: **19.12.89**

(51) Int. Cl.5 **G03F 7/16, H05K 1/00**

(30) Priority: **23.12.88 US 289120**

(43) Date of publication of application:
**27.06.90 Bulletin 90/26**

(84) Designated Contracting States:
**CH DE FR GB IT LI NL SE**

(71) Applicant: **E.I. DU PONT DE NEMOURS AND COMPANY**
**1007 Market Street**
**Wilmington Delaware 19898(US)**

(72) Inventor: **Stout, Gary Karl**
**927 Paul Street**
**Gloucester New Jersey 08030(US)**

(74) Representative: **Werner, Hans-Karsten, Dr. et al**
**Deichmannhaus am Hauptbahnhof**
**D-5000 Köln 1(DE)**

(54) **Bubble free film/liquid solder mask-coated printed circuit boards by fluid pressurizing.**

(57) A method is disclosed of obtaining a bubble free laminate employing an intermediate liquid layer by applying uniform fluid pressure after lamination.

EP 0 374 809 A2

# BUBBLE FREE FILM/LIQUID SOLDER MASK-COATED PRINTED CIRCUIT BOARDS BY FLUID PRESSURIZING

## Background of the Invention

The present invention is directed to a method of obtaining a substantially bubble free liquid interface between a substrate surface and a photopolymerizable dry film applied thereto. The present invention is particularly adapted to application of a soldermask in the manufacture of a printed circuit board.

Lau et al. U.S. Patent 4,698,294 discloses a process for applying a photopolymerizable film onto a substrate employing an intermediate nonphotosensitive liquid layer which is substantially all monomer.

Sullivan U.S. Patent 4,506,004 discloses various embodiments of obtaining printed wiring boards by means of a two layer composite coating. In one embodiment an adhesive photopolymer layer is applied to a printed wiring board in a liquid state displacing air from the printed wiring board surface. A dry film soldermask is temporarily adhered to the underside of a screen printing frame and applied onto the liquid layer prior to processing of the photopolymer layer. In another of the embodiments of the patent nonphotoimaging epoxy layers can be employed.

Oizuma et al. U.S. Patent 4,388,129 discloses a method for impregnating a porous fibrous substrate with a solvent-free liquid resin, allowing substantially all entrapped air bubbles to disappear by dissolving into the liquid resin and curing the combination. The air bubbles can be eliminated by standing for a sufficient period of time which may be shortened by applying ultrasonic waves, by placing the green laminate in compressed air or by using degassed liquid resin.

## Summary of the Invention

The present invention is directed to a method of obtaining a substantially bubble free laminate employing an intermediate liquid layer between a dry film photopolymerizable layer and a substrate surface comprising the steps of (a) applying at least one liquid layer to the substrate surface; (b) applying the dry film photopolymerizable layer onto the substrate wherein the liquid layer is intermediate the substrate and the dry film layer to form a laminate; (c) applying uniform elevated pressure of at least 0.3 atmospheres above ambient pressure uniformly to the laminate by a pressurized fluid whereby any bubbles or voids entrapped in the liquid layer or interface thereof are eliminated; and (d) releasing the uniform elevated pressure.

## Detailed Description of the Invention

The present invention is considered to be an improved method over the process disclosed in Lau et al. U.S. Patent 4,698,294 which is incorporated by reference herein. Accordingly various portions of the patent are reproduced herein.

Lau et al. discloses a process for laminating a photopolymerizable film onto a substrate which comprises the steps of

(a) applying to a substrate surface or a photopolymerizable film surface which is preformed and nonliquid a liquid which is substantially nonphotosensitive to actinic radiation and which consists essentially of at least one nongaseous ethylenically unsaturated compound containing at least one ethylenic group having a boiling point above $100°$ C at normal atmospheric pressure and being capable of forming a high polymer by addition polymerization;

(b) laminating the substrate and preformed nonliquid photopolymerizable film through the applied liquid whereby excess liquid is present during the lamination and is forced along at least one edge of the laminated substrate and film;

(c) exposing imagewise to actinic radiation the photopolymerizable film and the liquid;

(d) removing unexposed areas of the photopolymerizable film and the liquid from the substrate.

In the present invention the liquid which can be employed can be other than the liquid disclosed by Lau U.S. Patent 4,698,294, for example, photosensitive liquids can be employed including liquids photopolymerizable by actinic radiation such as disclosed by Hauser U.S. Patent 4,528,261 and Sullivan U.S. Patent 4,506,004.

The substrates which are coated are varied and can be rigid or flexible. The substrate can be relatively smooth, i.e., having a substantially planar surface or can be nonplanar, i.e., having a raised relief with conductive and nonconductive surface areas. Lamination of a photopolymerizable film (which is not a liquid and is generally present as a solid film layer) to a substrate surface can present undesirable results such as due to insufficient adhesion or due to air entrapment. These problems are present with planar substrates and are even more prevalent with substrates having a raised relief. Rough surfaces can be present on planar substrates, e.g., copper cladding applied to an insulating core such as an epoxy-glass fiber weave which causes the cladding to follow the undulations of the glass fiber. With substrates having a raised relief particularly due to conductive and nonconductive surface portions, air entrapment can readily occur since dry film in many cases cannot follow the surface configuration. Conventionally substrates will have channels, i.e., holes, extending through the substrate to allow electrical connections to be made to an opposite surface.

The photopolymerizable film which is laminated to the substrate can be chosen from a wide variety of photoresist and solder mask films particularly those which are commercially available. In the present disclosure it is understood that photopolymerizable film and photopolymerizable layer is inclusive of one or more coatings present with the photopolymerizable portion, e.g., a subbing coating present with the photopolymerizable portion. In the case where a solder mask film is applied to a substrate having a raised relief particularly due to circuitry the photopolymerizable film can be thinner than normally employed such as in a range from 0.3 mils to 4.0 mils but preferably 1.0 mils to 2.0 mils. The photopolymerizable film normally is adhered to a support film which is removed subsequent to the lamination procedure. Illustrative of the many patents which disclose various film formulations are USP 3,469,982 and USP 4,293,635. Typically the photoresist-forming layer is a single layer as disclosed in Celeste U.S. Patent 3,469,982, however, the layer may itself be composed of a number of individual component layers having specialized functions such as those disclosed in Cyr et al. U.S. Patent 4,347,620 and Christensen et al. U.S. Patent 4,530,896.

A problem which exists in lamination of a dry solder mask film directly to a substrate having a raised relief is that air can be easily entrapped between the film and substrate. Use of a liquid is known to displace air during the lamination.

However the invention is broader in scope since advantages are present both with planar and raised relief substrate surfaces. Criticality is not present in the type of liquid intermediate layer, the photopolymerizable film and the substrate surface. The liquid can be primarily a compound which is capable of forming a high polymer by photoinitiated polymerization and should have a controlled viscosity such as described in Lau USP 4,698,294.

Also the liquid can be photopolymerizable and contain binders, monomers and photoinitiators and photoinhibitors. As mentioned liquids include those disclosed in Hauser USP 4,528,261 and Sullivan USP 4,506,009 incorporated by reference herein for suitable liquids.

To exemplify the components that can be included in the liquid which may or may not be photosensitive the following is provided:

Monomers: t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, trimethylolpropane triacrylate, pentaerythritol triacrylate, 2,2-di(p-hydroxyphenyl)-propane diacrylate, pentaerythritol tetraacrylate, 2,2-di-(p-hydroxyphenyl)-propane dimethacrylate, triethylene glycol diacrylate, polyoxyethyl-2,2-di(p-hydroxyphenyl)-propane dimethacrylate, di-(3-methacryloxy-2-hydroxypropyl) ether of Bisphenol-A, di-(2-methacryloxyethyl) ether of Bisphenol-A, di-(3-acryloxy-2-hydroxypropyl) ether of Bisphenol-A, di-(2-acryloxyethyl) ether of Bisphenol-A, di-(3-methacryloxy-2-hydroxypropyl) ether of tetrachloro-Bisphenol-A, di-(2-methacryloxyethyl) ether of tetrachloro-Bisphenol-A, di-(3-methacryloxy-2-hydroxypropyl) ether of tetrabromo-Bisphenol-A, di-(2-methacryloxyethyl) ether of tetrabromo-Bisphenol-A, di-(3-methacryloxy-2-hydroxypropyl) ether of 1,4-butanediol, di-(3-methacryloxy-2-hydroxypropyl) ether of diphenolic acid, triethylene glycol dimethacrylate, polyoxypropyltrimethylol propane triacrylate (462), ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzene, and 1,3,5-triisopropenyl benzene.

In addition to the ethylenically unsaturated monomers mentioned above, the photohardenable layer can also contain at least one of the following free-radical initiated, chain-propagating, addition polymerizable, ethylenically unsaturated compounds having a molecular weight of at least 300. These monomers include, preferably, an alkylene or a polyalkylene glycol diacrylate prepared from an alkylene glycol of 2 to 15 carbons or a polyalkylene ether glycol of 1 to 10 ether linkages, and those disclosed in U.S. Patent No. 2,927,022, which is incorporated by reference, e.g., those having a plurality of addition polymerizable ethylenic linkages, particularly when present as terminal linkages, and especially those wherein at least one and preferably most of such linkages are conjugated with a double bonded carbon, including carbon doubly bonded to carbon and to such hetero atoms as nitrogen, oxygen and sulfur. Outstanding are such materials wherein the ethylenically unsaturated groups, especially the vinylidene groups, are conjugated with ester or amide structures.

Initiators: substituted or unsubstituted polynuclear quinones which are compounds having two intracyclic carbon atoms in a conjugated carbocyclic ring system. Suitable such initiators include 9,10-anthraquinone, 1-chloroanthraquinone, 2-chloroanthraquinone, 2-methylanthraquinone, 2-ethylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloroanaphthoquinone, 1,4-dimethylanthraquinone, 2,3-dimethylanthraquinone, 2-phenylanthraquinone, 2,3-diphenylanthraquinone, sodium salt of anthraquinone $\alpha$-sulfonic acid, 3-chloro-2-methylanthraquinone, retenequinone, 7,8,9,10-tetrahydronaphthacenequinone, and 1,2,3,4-tetrahydrobenz(a) anthracene-7,12-dione. Other photoinitiators which are also useful, even though some may be thermally active at temperatures as low as 85°C, are described in Plambeck U.S. Patent No. 2,760,863 and include vincinal ketaldonyl compounds, such as diacetyl, benzil, etc.; $\alpha$-ketaldonyl alcohols, such as benzoin, pivaloin, etc.; acyloin ethers, e.g., benzoin methyl and ethyl ethers, etc; $\alpha$-hydrocarbon substituted aromatic acyloins, including $\alpha$-methylbenzoin, $\alpha$-allylbenzoin and $\alpha$-phenylbenzoin. In addition the photoreducible dyes and reducing agents disclosed in U.S. Patent Nos. 2,850,445; 2,875,047; 3,097,096; 3,074,974; 3,097,097; and 3,145,104 as well as dyes of the phenazine, oxazine, and quinone classes may be used. Other suitable polymerization initiators are Michler's ketone, benzophenone 2,4,5-triphenylimidazolyl dimers with hydrogen donors, and mixtures thereof as described in U.S. Patent Nos. 3,427,161; 3,479,185 and 3,549,367.

All the aforementioned U.S. patents and applications are incorporated by reference.

Binders: Binders can be used individually or in combination or in combination with filler material to adjust viscosity of the photosensitive liquid. Typical binders include: polyacrylate and $\alpha$-alkyl polyacrylate esters, e.g., polymethyl methacrylate and polyethylmethacrylate; polyvinyl esters, e.g., polyvinyl acetate, polyvinyl acetate/acrylate, polyvinyl acetate/methacrylate and hydrolyzed polyvinyl acetate; ethylene/vinyl acetate copolymers; polystyrenes; vinylidene chloride copolymers, e.g., vinylidene chloride/acrylonitrile, vinylidene chloride/methacrylate and vinylidene chloride/vinyl acetate copolymers; polyvinyl chloride and copolymers, e.g., polyvinyl chloride/acetate; high molecular weight polyethylene oxides of polyglycols having average molecular weights of 4000 to 1,000,000; epoxides; copolyesters, e.g., those prepared from the reaction product of a polymethylene glycol of the formula $HO(CH_2)_nOH$, where n is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids; synthetic rubbers, e.g., butadiene/acrylonitrile, acrylonitrile/butadiene (carboxy-modified, e.g., 3%) acrylonitrile/butadiene/styrene, alkyl (1 to 4 carbon atoms) methacrylate/acrylonitrile/butadiene, alkyl (1 to 4 carbon atoms) methacrylate/styrene/acrylonitrile/butadiene interpolymers, 2-chlorobutadiene/1,3-polymers, chlorinated rubber, styrene/butadiene/styrene, styrene/isoprene/styrene block copolymers and other block copolymers described by Holden et al. in U.S. Patent 3,265,765 which is incorporated by reference, n-butyl methacrylate, polyether polyurethane resin, etc., nylons or polyamides, e.g., N-methoxymethyl polyhexamethylene adipamide; cellulose esters, e.g., cellulose acetate, cellulose acetate succinate and cellulose acetate butyrate; cellulose ethers, e.g., methyl cellulose, ethyl cellulose and benzyl cellulose, polycarbonates; polyvinyl acetal, e.g., polyvinyl butyral, polyvinyl formal; polyformaldehydes.

In the laminating procedure it is necessary that adherence of the substrate and film be obtained through the liquid, i.e., delamination does not occur. Since the photopolymerizable film is conventionally supported by another film (which is well known in the art), the adherence of the laminated layers is sufficient to allow removal of the support film from the photopolymerizable film either before or after exposure of the photopolymerizable film to actinic radiation. Suitable support films which cover the photopolymerizable film or its surface which is not laminated include, e.g., transparent polyethylene terephthalate. Disclosures of support films are taught in, e.g., USP 3,469,982 and USP 4,293,635.

If the adherence between the substrate and film through the liquid is insufficient after the lamination procedure, another combination of monomer liquid and photopolymerizable film is generally employed. Either another liquid or another film can be utilized. However, in some instances an extended hold time, e.g., greater than 15 minutes, can act to increase adhesion. Also with excessively thick liquid layers, a decrease in the layer may overcome the problem of insufficient adhesion.

With a planar or substantially planar substrate both low and high viscosity liquids can be employed although a high viscosity liquid will generally take more time to apply. Also high viscosity liquids have a tendency to trap air which is undesirable. If a liquid monomer has an unduly high viscosity, a combination of other components, e.g., monomers can be used, e.g., high and low viscosity monomers. However for substrates which have a raised relief relatively low viscosity liquids are preferred particularly due to the need to remove air which can be entrapped. Generally the viscosity of the liquid in such case will not be greater than 400 centipoise and more preferably not greater than 200 centipoise. A most preferred range of viscosity is from 5 to 50 centipoise. Typically the raised relief will be at least 0.7 mil with typical circuit heights ranging from 1.4 mils to 4.0 mils and higher.

Generally the liquid is applied in excess over the amount used to form a layer between the substrate and photopolymerizable film and a moving pressure front forces excess liquid along at least one side portion of the two surfaces as they are laminated onto each other. Since the liquid can be employed in excess, various techniques of application are possible to obtain a liquid layer between the substrate and film surface. The liquid can be applied to the substrate, the film or both such as an interface formed by these materials. Conventionally a pressure roller can be employed which applies pressure to the film in a laminating operation and squeezes excess liquid as a moving front ahead of the pressure roller as it contacts the photopolymerizable film. Liquid will generally escape from two side portions of the substrate and film (i.e., parallel to the direction of movement in the lamination procedure) if the lamination procedure is undertaken with the substrate in a horizontal position. with lamination in a vertical mode (e.g. the substrate is held vertically and travels in a horizontal direction), liquid will generally escape from at least the bottom edge.

Removal of the excess liquid along the sides of the substrate and film is undertaken prior to the exposure step of the photopolymerizable film to actinic radiation if the liquid contaminates the phototool or other contacting equipment. With out-of-contact exposure, removal of excess liquid may not be necessary since the liquid does not touch a phototool. The manner of liquid removal is varied and preferably involves a spray of another liquid composition which serves to cause physical removal. Preferably the liquid is not a solvent for the photopolymerizable film. A hydrophilic liquid such as water is preferred. Another technique for excess removal of the monomer liquid is by physically scraping the substrate and film although such method can tear the film. For optimum results the laminated substrate ordinarily will conventionally have a dry surface prior to exposure to actinic radiation (unless exposure is through a liquid interface such as disclosed in USP 4,518,667).

Since an important advantage of such coating liquid in combination with the dry photopolymerizable film is the ability to tent over holes in a substrate, i.e., cover the hole in the lamination procedure without breaking the film or adversely plugging the hole, the viscosity of the coating liquid tailored to the hole size is important. The viscosity will generally not be greater than 400 centipoise and generally not greater than 200 centipoise for solder mask utility wherein the substrates have a raised relief. More preferably the viscosity of the liquid will be in the range of 5 to 50 centipoise. Holes in the substrate, i.e., channels, are generally in the range of from 10 to 250 mils. An optimum liquid viscosity for a given hole or different size holes on a single substrate can be readily determined by application of different viscosity liquids to the substrate and evaluating the results obtained. For hole filling, small holes, e.g. (10 to 40 mil diameter) can be filled more readily with lower viscosity liquids (e.g. 1 to 100 centipoise) and tented by the film as well. On the other hand large holes remain filled with higher viscosity materials (lower viscous liquids drain rapidly) such that a successful tent can be achieved.

After the lamination procedure the photopolymerizable film is processed in a known manner including imagewise exposure to actinic radiation and development in a liquid which removes nonphotopolymerized areas of the film to expose portions of the substrate to allow, e.g., plating or etching. The photopolymerized film may be stripped from the substrate or it may remain permanently in place such as with use of the film as a solder mask to protect areas of the substrate from application and adherence of molten solder.

In the present invention it is considered that the prior art liquid/film lamination processes, as exemplified by the Lau et al. process described above, while generally useful in excluding air from laminate structures are still unsatisfactory in certain instances where microbubbles or voids are present in the liquid interface between the substrate and the laminated photopolymerizable film. In the production of printed circuit boards and in the use of liquid/dry film as a solder mask on a substrate surface having a raised circuit relief, the presence of microbubbles or voids becomes critical when the spacing between the raised circuit conducting areas decreases such as with high density circuit boards. When the dimensions of the microbubbles or voids become significant in relationship to the intervening dielectric surface between adjacent conductive circuit lines, the electrical characteristics of the circuit are typically affected leading in some instances to poor mask adhesion and to electrical shorts during the soldering process. In the present invention it has been found that microbubbles or voids present in such high density, liquid/film, circuit laminates can be eliminated permanently by immersing the laminate in a pressurized fluid, e.g., compressed air, for a short duration. Not only are the microbubbles eliminated, e.g., dissolved into the liquid interface layer, but they do not reappear when the laminate is removed from the pressurized fluid even upon standing or further processing. In effect, immersion in a pressurized fluid applies a uniform pressure to all areas and in all directions to the immersed laminate without adversely affecting the physical and exposure characteristics of the photopolymerizable circuit laminate.

Typically in the practice of this invention, the laminated structure after exiting the laminator is then placed in a pressure chamber and the fluid pressure of the chamber raised to at least about 0.3 atmospheres and preferably at least about 3 atmospheres above ambient for a duration of about 1 minute or more typically between about 1 minute and about 10 minutes. Although the preferred fluid is. air or nitrogen, liquids such as water or inert organic materials or solutions thereof may be used. The fluid pressurization conditions may be adjusted in several ways to insure bubble or void free printed circuit laminates. For liquid/film laminated solder masks, laminates typically are rendered bubble free by pressurizing in air at room or ambient temperature, e.g., 25 to 30°C, at about 5 to 6 atmospheres (i.e., about 74 to 88 psi) above ambient for about 1 minute. By increasing the laminate temperature, the time duration needed to produce bubble free laminates can be reduced below 1 minute or the fluid pressure needed can be reduced. Alternately, the time needed to produce bubble free laminates may be increased beyond 1 minute by reducing the fluid pressure applied, e.g. down to about 0.3 atmospheres (about 5 psi) above ambient, and/or the laminate temperature below room temperature. The actual conditions used may be chosen to accommodate the specific method used to pressurize the laminate structure and insure the integrity of the bubble free laminate before imaging exposure. Fluid pressurization may be carried out in a batch process wherein a number of laminated structures are placed in a chamber and fluid pressure raised, or it may be carried out in a sequential, in-line process wherein each laminate after it exits the laminator, enters a fluid pressurization chamber for a duration needed to insure bubble and void free laminates.

Although this invention has been described in the context of the Lau et al. process, it is equally applicable to any other liquid/film application systems. Such systems include, but is not limited thereby, the systems of Sullivan U.S. Patent 4,506,004 and the like which discloses the use of photopolymerizable and thermally curable liquids. Likewise, the dry film used in the liquid/film system may be any photohardenable or imageable film that is compatible with the liquid. Liquids may be applied to the substrate surface by any prior art or conventional means either as neat liquid or as a solvent solution in which case the solvent is typically removed prior to application of the dry film.

To further illustrate the present invention the following examples are provided.

## EXAMPLE 1

Coat a series of printed circuit board panels of a size 18" x 24" containing a raised relief height of about 3.5 mils on both panel surfaces with approximately 2400 holes ranging in size from 17 mils to 35 mils diameter with tripropyleneglycol diacrylate (TRPGDA) (having a viscosity of 14.5 centipoise at 25°C) via a wetting sponge. The liquid need not be applied uniformly but rather in an excessive amount used to form a liquid layer in a subsequent lamination procedure.

Pass the monomer wet panels while held in a vertical position through a nip of two rolls while laminating Vacrel® 8000 solder mask film of 1.5 mil thickness onto the wet panels. Maintain the temperature of the rolls in the range of 70° to 100°F with nip pressure of about 35 psi controlled by air cylinders. Each roll is of a type employed in a Riston® "I" System laminator with a Teflon® polytetrafluoroethylene sleeve covering a normal rubber coating.

In the lamination procedure maintain the monomer liquid coating in a thickness of about 0.2 mils measured away from the raised relief of the panel, e.g., with the coating ranging to about 3.5 mils immediately adjacent to the raised relief and approximately 0.2 mils above the raised relief.

Trim the panel edges and remove residual monomer liquid by a spray of water.

Place several laminated panels having visible microbubbles in the circuit pattern area in a sealed pressure chamber at room temperature (about 68°F or about 20°C). Using compressed air, bring the chamber to 80 psi (about 5.4 atmospheres above ambient) for two minutes. During this time the monomer will experience an increase in pressure equal to that of the chamber pressure. Any microbubbles present in the liquid will become visibly smaller and eventually entirely diffuse into the monomer liquid. After two minutes return the chamber to ambient atmospheric pressure and remove the panels. Under examination with a 200X optical microscope, no bubbles or voids should be visible.

Hold the panels for 30 minutes after lamination and then expose for 120 units (12 seconds) on Du Pont's PC-130 5KW exposure unit. After exposure remove the Mylar® polyester coversheet and develop the sample in an ASI processor with a 1% aqueous sodium carbonate solution at 105° F. Development time is about 75 seconds. After development cure the boards in an Argus UV unit and then thermally bake for 1 hour at 300° F.

The boards will give successful results as a solder mask when evaluated in a typical manner for solder mask properties including tests for solder resistance, solvent resistance, electrical properties, adhesion, thermal shock resistance and flammability. Testing follows the standard specification procedure recommended by the Institute for Interconnecting and Packaging Electronic Circuits present in their publication IPC-SM-840.

## EXAMPLE 2

The same process as Example 1 is performed except the liquid is modified by the addition of a small amount of Cymel®303 crosslinking agent mixed with tripropylene glycol diacrylate monomer. Only a few microbubbles should be evident after lamination and the bubbles will be removed during the post-lamination air pressurization. The thermal bake can be reduced to 30 min at 300° F and can be more effective than the sample without thermal crosslinker.

## EXAMPLE 3

Riston®3813 film is laminated over a double sided copper clad panels wet with TRPGDA monomer and pressurized in similar fashion as in Example 1 except the lamination is undertaken at room temperature. Panels with and without through holes are employed. The laminated panel is given 50 mj/cm² exposed (Du Pont PC-130 for 5 sec.); developed in an ASI processor at 85° for 40 sec in a 1% aqueous sodium carbonate developer solution. Etching is performed in a Chemcut etcher using an acidic ferric chloride etching solution. Etch times are dependent upon copper thickness. After etching, the resist is removed in a 2% aqueous potassium hydroxide solution at 140° F. Satisfactory results are again obtained.

## EXAMPLE 4

The process of Example 1 is repeated on various sample substrates of an insulating layer of a glass-epoxy weave with all different types of metal circuitry (e.g., copper, solder, gold) to form a raised relief. Substrate thickness varies from 30 mils to 90 mils with a circuit height from 1.4 to 4.0 mils. Panels with various metallized circuit patterns have through holes metallized in a similar manner such that each side of the board is electrically connected to the other. Hole size varies from about 12 mils to 250 mils. Successful test results are obtained.

## Claims

1. A method of obtaining a substantially bubble free laminate employing an intermediate liquid layer between a dry film photopolymerizable layer and a substrate surface comprising the steps of
(a) applying at least one liquid layer to the substrate surface;
(b) applying the dry film photopolymerizable layer onto the substrate wherein the liquid layer is intermediate the substrate and the dry film layer to form a laminate;
(c) applying uniform elevated pressure of at least 0.3 atmospheres above ambient pressure uniformly to the laminate by a pressurized fluid whereby any bubbles or voids entrapped in the liquid layer or interface thereof are eliminated; and
(d) releasing the uniform elevated pressure.

2. The method of claim 1 wherein the elevated pressure is at least 3 atmospheres above ambient.

3. The method of claim 1 wherein a pressure chamber is employed which surrounds the substrate and dry film layer.

4. The method of claim 1 wherein the fluid is a gas.

5. The method of claim 4 wherein the fluid is air.

6. The method of claim 1 wherein the fluid contacts the dry film.

7. The method of claim 1 wherein the substrate has a raised relief.

8. The method of claim 1 wherein the film is imagewise exposed to actinic radiation.

9. The method of claim 1 wherein the liquid consists essentially of at least one nongaseous unsaturated compound.

10. The method of claim 1 wherein the liquid is photosensitive.

11. The method of claim 1 wherein the liquid is photopolymerizable.

12. The method of claim 1 wherein a subbing coating is present as a portion of the film layer and is present between the film layer and the liquid.

13. The method of claim 1 wherein the fluid is a pressurizing liquid.

14. The method of claim 13 wherein the pressurizing liquid is water.

15. The method of claim 1 wherein the dry film photopolymerizable layer has a backing layer releasedly adhered thereto.

16. The method of claim 15 wherein the photopolymerizable layer is comprised of two or more component layers wherein at least one of the component layers is photopolymerizable.

17. The method of claim 1 wherein the pressurized fluid is applied at ambient temperature.

18. The method of claim 1 wherein the pressurized fluid is applied for a duration between about 1 minute and about 10 minutes.

19. The method of claim 1 wherein the pressurized fluid is applied for a duration of about 1 minute or less.